(19) **Europäisches Patentamt**
**European Patent Office**
**Office européen des brevets**

(11) **EP 2 242 065 A1**

(12) **EUROPEAN PATENT APPLICATION**
published in accordance with Art. 153(4) EPC

(43) Date of publication:
**20.10.2010 Bulletin 2010/42**

(21) Application number: **09707515.4**

(22) Date of filing: **05.02.2009**

(51) Int Cl.:
*H01B 5/00* $^{(2006.01)}$     *B22F 1/02* $^{(2006.01)}$
*H01B 13/00* $^{(2006.01)}$     *H01R 11/01* $^{(2006.01)}$

(86) International application number:
**PCT/JP2009/051964**

(87) International publication number:
**WO 2009/099143 (13.08.2009 Gazette 2009/33)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **05.02.2008 JP 2008025103**
           **13.11.2008 JP 2008291272**

(71) Applicant: **Hitachi Chemical Company, Ltd.**
**Tokyo 163-0449 (JP)**

(72) Inventors:
• **TAKAI, Kenji**
**Tsukuba-shi**
**Ibaraki 300-4247 (JP)**

• **MATSUZAWA, Mitsuharu**
**Chikusei-shi**
**Ibaraki 308-8524 (JP)**
• **NAGAHARA, Yuuko**
**Chikusei-shi**
**Ibaraki 308-8524 (JP)**
• **AKAI, Kunihiko**
**Chikusei-shi**
**Ibaraki 317-8555 (JP)**

(74) Representative: **HOFFMANN EITLE**
**Patent- und Rechtsanwälte**
**Arabellastrasse 4**
**81925 München (DE)**

(54) **CONDUCTIVE PARTICLE AND METHOD FOR PRODUCING CONDUCTIVE PARTICLE**

(57)     A conductive particle 8a comprising a core particle 11, a palladium layer 12 coating the core particle 11 and having a thickness of 200 Å or larger, and an insulating particle 1 arranged on the surface of the palladium layer 12 and having a particle diameter larger than the thickness of the palladium layer 12.

*Fig.1*

EP 2 242 065 A1

## Description

**Technical Field**

The present invention relates to a conductive particle and a method for producing a conductive particle.

**Background Art**

Methods for mounting a liquid crystal display driver IC on a liquid crystal display glass panel are classified roughly in two types: chip-on-glass (COG) mounting and chip-on-flex (COF) mounting.

In COG mounting, a liquid crystal display driver IC is directly bonded on a glass panel by using an anisotropic conductive adhesive containing conductive particles. By contrast, in COF mounting, an liquid crystal display driver IC is bonded to a flexible tape having metal wiring, and then they are bonded to a glass panel by using an anisotropic conductive adhesive containing conductive particles. The term "anisotropic" herein means having electrical conductivity in a pressurized direction and maintaining electrical insulation in a non-pressurized direction.

Because liquid crystal displays have been designed to have higher resolution recently, bumps acting as circuit electrodes for an liquid crystal display driver IC have narrower pitches therebetween and smaller areas. As a result, conductive particles in an anisotropic conductive adhesive problematically flow out between adjacent circuit electrodes to cause short circuiting.

When conductive particles flow out between adjacent circuit electrodes, problems arise in that the number of conductive particles in an anisotropic conductive adhesive supplemented between bumps and a glass panel is reduced, connection resistance between circuit electrodes facing each other is increased, and thus disconnection occurs therebetween.

To solve these problems, Patent Document 1 discloses a method in which an insulating adhesive is provided on at least one surface of an anisotropic conductive adhesive to prevent deterioration in bonding quality in COG mounting or COF mounting. Patent Document 2 discloses a method in which the entire surface of a conductive particle is coated with an insulating coat.

Patent Documents 3 and 4 disclose a method in which the core particle of a high molecular weight polymer coated with a gold layer is covered with insulating child particles. Furthermore, Patent Document 4 discloses a method in which the surface of the gold layer coating the core particle is treated with a compound containing any of a mercapto group, a sulfide group and a disulfide group to form a functional group on the surface of the gold layer. Accordingly, a strong functional group can be formed on the gold layer.

Patent Document 5 discloses a method in which a resin fine particle is plated with copper/gold as an attempt to enhance conductivity of a conductive particle.

Patent Document 6 discloses a conductive particle comprising a nonmetallic fine particle, a metal layer coating the nonmetallic fine particle and containing copper in an amount of 50% by weight or more, a nickel layer coating the metal layer, and a gold layer coating the nickel layer. It also discloses that this conductive particle provides higher conductivity than a general conductive particle of nickel and gold.

Patent Document 7 discloses a conductive particle comprising a base fine particle and a metal coating layer provided on the base fine particle, and the content of gold in the metal coating layer is 90% by weight or more and 99% by weight or less.

**Citation List**

**Patent Literature**

Patent Document 1: JP-H8-279371A
Patent Document 2: Japanese Patent No. 2794009
Patent Document 3: Japanese Patent No. 2748705
Patent Document 4: WO 03/02955
Patent Document 5: JP-2006-028438A
Patent Document 6: JP-2001-155539A
Patent Document 7: JP-2005-036265A

## Summary of Invention

### Technical Problem

As disclosed in Patent Document 1, however, in the method in which the insulating adhesive is provided on one surface of a circuit connecting member, when the area of a bump is made smaller than 3000 $\mu m^2$, the number of conductive particles in the circuit connecting member needs to be increased to provide stable connection resistance. In such a case where the number of conductive particles is increased, there is still room for improvement in electrical insulation between adjacent electrodes.

As disclosed in Patent Document 2, the method in which the entire surface of a conductive particle is coated with the insulating coat to improve electrical insulation between adjacent electrodes provides higher electrical insulation between the circuit electrodes, however, conductivity of the conductive particle tends to be lowered.

As disclosed in Patent Documents 3 and 4, in the method in which the surface of a conductive particle is covered with the insulating child particles, child particles made of acrylic or other resin need to be used in terms of adhesiveness between the child particles and the conductive particle. In this case, by melting the resin child particles in thermocompression bonding of the circuits and causing the conductive particle to be in contact with both circuits, the circuits become electrically conductive. It has been found that if the molten resin of the child particles coats the surface of the conductive particle in this process, conductivity of the conductive particle is likely to be lowered in a similar manner to the method of coating the entire surface of a conductive particle with an insulating coat. For these reasons, insulating child particles having relatively high hardness and high melting temperature, such as inorganic oxides, are suitably used. For example, Patent Document 4 discloses a method in which a silica surface is treated with 3-isocyanatepropyltriethoxysilane to react silica having an isocyanate group on the surface thereof with a conductive particle having an amino group on the surface thereof.

It is generally difficult, however, to modify the surface of a particle having a particle diameter of 500 nm or smaller with functional groups, and in centrifugation or filtration after being modified with the functional groups, a problem is likely to occur in that inorganic oxides, such as silica, agglutinate. Furthermore, with the method disclosed in Patent Document 4, it is difficult to control the coverage of the insulating child particles.

When treating a metal surface with a compound containing any of a mercapto group, a sulfide group and a disulfide group, if even a little amount of easily oxidizable metal including base metal, such as nickel, or copper is present on the metal, the reaction of the metal with the compound is hard to progress.

The present inventors have found through their studies that, in the case where the conductive particle is covered with an inorganic substance, such as silica, conductivity is effected by silica crushing the metal surface on the conductive particle. Because silica thus breaks the conductive metal, if the conductive metal contains substances other than noble metal, migration characteristics tend to be deteriorated.

As disclosed in Patent Document 6, a type of a conductive particle prepared by plating a nickel layer with gold becomes mainstream recently. Such a conductive particle, however, has a problem in that nickel is eluted to cause migration. When the thickness of the gold plating is set to 400 Å or smaller, this tendency is significant.

As disclosed in Patent Document 7, the conductive particle coated with the metal coating layer containing gold in an amount of 90% by weight or more is excellent in terms of reliability, but incurs high cost. Accordingly, the conductive particle having a metal coating layer with a high gold content is hard to be practically applicable, and the content of gold in the metal coating layer tends to be lowered recently. By contrast, a conductive particle having copper plating is excellent in terms of conductivity and cost. The conductive particle having copper plating, however, has a problem in terms of moisture absorption resistance, because it is likely to cause migration. Therefore, attempts to compensate for the disadvantages of the both (gold and copper) have been made, but none of them are perfect. For example, the method disclosed in Patent Document 5 fails to sufficiently compensate for the disadvantages of the both (gold and copper).

In view of the problems described above, an object of the present invention is to provide a conductive particle that causes no migration, requires low cost, has high conductivity, and provides high connection reliability between electrodes, and to provide a method for producing such a conductive particle.

### Solution to Problem

To achieve the object described above, a conductive particle according to a first aspect of the present invention comprises a core particle, a palladium layer coating the core particle and having a thickness of 200 Å or larger, and an insulating particle arranged on the surface of the palladium layer and having a particle diameter larger than the thickness of the palladium layer.

When an anisotropic conductive adhesive (anisotropic conductive film) prepared by dispersing a plurality of such conductive particles in an adhesive is applied between a pair of electrodes, and when the pair of electrodes is connected (thermocompression bonding), the whole conductive particles are compressed with the pair of electrodes in a vertical direction (direction in which the pair of electrodes faces each other). As a result, the insulating particle dents into the core particle side from the surface of the palladium layer, thus enabling the palladium layer exposed due to the denting to be in contact with the pair of electrodes. In other words, the pair of electrodes is electrically conductive via the palladium layer of the conductive particles. On the other hand, in a horizontal direction (direction perpendicular to the direction in which the pair of electrodes faces each other), insulating particles included in respective conductive particles are interposed between adjacent conductive particles, and the insulating particles are in contact with each other. Therefore, in the horizontal direction, electrical insulation is maintained between the pair of electrodes and the electrodes adjacent thereto.

According to the first aspect of the present invention, because the particle diameter of the insulating particle is larger than the thickness of the palladium layer, the insulating particle dents into the inside of the conductive particle without fail in thermocompression bonding. As a result, it is possible to achieve high conductivity between the pair of electrodes.

According to the first aspect of the present invention, when connecting a pair of electrodes by using the anisotropic conductive adhesive containing the conductive particles, because the palladium layer has ductility, the palladium layer is hard to crack even after the conductive particles are compressed. Therefore, it is possible to enhance conductivity of the conductive particle after being compressed and connection reliability between the electrodes, and also to prevent migration of palladium due to a crack in the palladium layer. Because palladium is economical and practically applicable compared with noble metal, such as gold and platinum, the conductive particle having the palladium layer according to the first aspect of the present invention is provided at lower cost than a conductive particle using gold or platinum alone.

According to the first aspect of the present invention, because the thickness of the palladium layer is 200 Å or larger, it is possible to provide sufficient conductivity.

A conductive particle according to a second aspect of the present invention comprises a core particle, a conductive layer coating the core particle, a palladium layer coating the conductive layer and having a thickness of 200 Å or larger, and an insulating particle arranged on the surface of the palladium layer and having a particle diameter larger than the sum of the thicknesses of the conductive layer and the palladium layer.

Using the conductive particle according to the second aspect of the present invention for an anisotropic conductive adhesive causes, in a similar manner to the first aspect of the present invention, a pair of electrodes to be electrically conductive via the palladium layer in a vertical direction, and electrical insulation to be maintained between the pair of electrodes and electrodes adjacent thereto in a horizontal direction.

According to the second aspect of the present invention, because the particle diameter of the insulating particle is larger than the sum of the thicknesses of the conductive layer and the palladium layer, the insulating particle dents into the inside of the conductive particle without fail in thermocompression bonding. As a result, it is possible to achieve high conductivity between the pair of electrodes.

According to the second aspect of the present invention, because the palladium layer has ductility, in a similar manner to the first aspect of the present invention, it is possible to enhance conductivity of the conductive particle after being compressed and connection reliability between the electrodes, and also to prevent migration of palladium. Because the conductive layer is coated with the palladium layer, the palladium layer prevents migration of the conductive layer. In addition, because palladium is economical and practically applicable compared with noble metal, such as gold and platinum, the conductive particle having the palladium layer according to the second aspect of the present invention is provided at lower cost than a conductive particle using gold or platinum alone.

According to the second aspect of the present invention, because the thickness of the palladium layer is 200 Å or larger and the conductive particle has the conductive layer, it is possible to provide sufficient conductivity. Furthermore, because the palladium layer has a large thickness of 200 Å or larger, migration of the conductive layer is readily prevented.

In the conductive particle according to the second aspect of the present invention, the conductive layer is preferably consisting of nickel. With the conductive layer consisting of nickel, which is economical and has high conductivity, the conductive particle is provided at further lower cost and the conductivity thereof is enhanced.

A conductive particle according to a third aspect of the present invention comprises a core particle, a palladium layer coating the core particle and having a thickness of 200 Å or larger, a gold layer coating the palladium layer, and an insulating particle arranged on the surface of the gold layer and having a particle diameter larger than the sum of the thicknesses of the palladium layer and the gold layer.

When a pair of electrodes is connected with an anisotropic conductive adhesive containing the conductive particles according to the third aspect of the present invention, the whole conductive particles are compressed with the pair of electrodes in a vertical direction. As a result, the insulating particle dents into the core particle side from the surface of the gold layer, and the pair of electrodes is electrically conductive via the gold layer exposed due to the denting. On the other hand, in a horizontal direction, the insulating particles included in respective conductive particles are interposed between adjacent conductive particles and the insulating particles are in contact with each other. Therefore, in the horizontal direction, electrical insulation is maintained between the pair of electrodes and the electrodes adjacent thereto.

According to the third aspect of the present invention, because the particle diameter of the insulating particle is larger than the sum of the thicknesses of the palladium layer and the gold layer, the insulating particle dents into the inside of the conductive particle without fail in thermocompression bonding. As a result, it is possible to achieve high conductivity between the pair of electrodes.

According to the third aspect of the present invention, because the palladium layer and the gold layer have ductility, the palladium layer and the gold layer are hard to crack even after the conductive particles are compressed. Therefore, it is possible to enhance conductivity of the conductive particle after being compressed and connection reliability between the electrodes, and also to prevent migration of palladium and gold due to a crack in the palladium layer or the gold layer. In addition, because palladium is economical and practically applicable compared with noble metal, such as gold and platinum, the conductive particle having the palladium layer according to the third aspect of the present invention is provided at lower cost than a conductive particle using gold or platinum alone.

According to the third aspect of the present invention, because the thickness of the palladium layer is 200 Å or larger, it is possible to provide sufficient conductivity. In addition, according to the third aspect of the present invention, because the gold layer with high conductivity is arranged on the outermost surface, it is possible to lower the surface resistance of the conductive particle and to enhance the conductivity of the conductive particle.

In the third aspect of the present invention, the gold layer is preferably a reduction plating type gold layer. With such a gold layer, the coverage of the gold layer with respect to the palladium layer is enhanced and the surface resistance of the conductive particle is readily lowered.

In the first, second or third aspect of the present invention, the palladium layer is preferably a reduction plating type palladium layer. With such a palladium layer, the coverage of the palladium layer with respect to the core particle is enhanced and the conductivity of the conductive particles is readily enhanced.

A method for producing the conductive particle according to the first aspect of the present invention comprises forming a palladium layer on the surface of a core particle, forming a functional group on the surface of the palladium layer by treating the surface of the palladium layer with a compound containing any of a mercapto group, a sulfide group and a disulfide group, and immobilizing an insulating particle by chemisorption on the surface of the palladium layer having the functional group formed thereon.

With the method for producing the conductive particle according to the first aspect of the present invention, it is possible to produce the conductive particle according to the first aspect of the present invention.

A method for producing the conductive particle according to the second aspect of the present invention comprises forming a conductive layer on the surface of a core particle, forming a palladium layer on the surface of the conductive layer, forming a functional group on the surface of the palladium layer by treating the surface of the palladium layer with a compound containing any of a mercapto group, a sulfide group and a disulfide group, and immobilizing an insulating particle by chemisorption on the surface of the palladium layer having the functional group formed thereon.

With the method for producing the conductive particle according to the second aspect of the present invention, it is possible to produce the conductive particle according to the second aspect of the present invention.

In the methods for producing the conductive particles according to the first or second aspect of the present invention, by treating the surface of the palladium layer with the compound containing any of a mercapto group, a sulfide group and a disulfide group, the compound is coordinate-bonded on the surface of the palladium layer, which makes it possible to form functional groups, such as a hydroxyl group, a carboxyl group, an alkoxyl group and an alkoxycarbonyl group, on the surface of the palladium layer. These functional groups form a covalent bond or a hydrogen bond with atoms on the surface of the insulating particle, and thus the insulating particle can be strongly chemisorbed on the surface of the palladium layer.

In the methods for producing the conductive particles according to the first or second aspect of the present invention, the surface of the palladium layer, which is hard to oxidize compared with a layer consisting of base metal, such as nickel, or copper, is treated with the compound. Therefore, reactivity of the surface of the palladium layer and the compound is enhanced compared with the case where a layer consisting of base metal, such as nickel, or copper is treated with the compound. Accordingly, the functional groups described above can be formed on the surface of the palladium layer without fail.

In the methods for producing the conductive particles according to the first or second aspect of the present invention, it is preferable that the insulating particle be immobilized on the surface of the palladium layer by chemisorption after the surface of the palladium layer having the functional group formed thereon is treated with a polymer electrolyte.

When the surface potential of the palladium layer provided with the functional groups and the surface potential of the insulating particle are both positive or negative, the insulating particle is difficult to be absorbed on the surface of the palladium layer. Therefore, by treating the surface of the palladium layer provided with the functional groups with the polymer electrolyte, the surface potential of the palladium layer is changed. Consequently, absorption of the insulating particle on the surface of the palladium layer is facilitated compared with the case of not being treated with the polymer electrolyte.

A method for producing the conductive particle according to the third aspect of the present invention comprises forming a palladium layer on the surface of a core particle, forming a gold layer on the surface of the palladium layer, forming a functional group on the surface of the gold layer by treating the surface of the gold layer with a compound containing any of a mercapto group, a sulfide group and a disulfide group, and immobilizing an insulating particle by chemisorption on the surface of the gold layer having the functional group formed thereon.

With the method for producing the conductive particle according to the third aspect of the present invention, it is possible to produce the conductive particle according to the third aspect of the present invention.

In the method for producing the conductive particle according to the third aspect of the present invention, by treating the surface of the gold layer with the compound containing any of a mercapto group, a sulfide group and a disulfide group, these compounds are coordinate-bonded on the surface of the gold layer, which makes it possible to form functional groups, such as a hydroxyl group, a carboxyl group, an alkoxyl group and an alkoxycarbonyl group, on the surface of the gold layer. These functional groups form a covalent bond or a hydrogen bond with atoms on the surface of the insulating particle, and thus the insulating particle can be strongly chemisorbed on the surface of the gold layer.

In the method for producing the conductive particle according to the third aspect of the present invention, the surface of the gold layer, which is difficult to oxidize compared with a layer consisting of base metal, such as nickel, or copper, is treated with the compound. Therefore, reactivity of the surface of the gold layer and the compound is enhanced compared with the case where a layer consisting of base metal, such as nickel, or copper is treated with the compound. Accordingly, the functional groups described above can be formed on the surface of the gold layer without fail.

In the method for producing the conductive particle according to the third aspect of the present invention, it is preferable that the insulating particle be immobilized on the surface of the gold layer by chemisorption after the surface of the gold layer having the functional group formed thereon is treated with a polymer electrolyte.

When the surface potential of the gold layer provided with the functional groups and the surface potential of the insulating particle are both positive or negative, the insulating particle is difficult to be absorbed on the surface of the gold layer. Therefore, by treating the surface of the gold layer provided with the functional groups with the polymer electrolyte, the surface potential of the gold layer is changed. Consequently, absorption of the insulating particle on the surface of the gold layer is facilitated compared with the case of not being treated with the polymer electrolyte.

In the method for producing the conductive particle according to the first, second or third aspect of the present invention, the functional group is preferably any of a hydroxyl group, a carboxyl group, an alkoxyl group and an alkoxycarbonyl group.

A hydroxyl group, a carboxyl group, an alkoxyl group or an alkoxycarbonyl group forms a strong bond with a hydroxyl group, such as a covalent bond by dehydration condensation or a hydrogen bond. Accordingly, if the insulating particle has a hydroxyl group on the surface thereof, and the functional group formed on the surface of the palladium layer or the gold layer is a hydroxyl group, a carboxyl group, an alkoxyl group or an alkoxycarbonyl group, the hydroxyl group on the surface of the insulating particle and the functional group on the surface of the palladium layer or the gold layer form a strong bond therebetween, thus enabling the insulating particle to be strongly absorbed on the surface of the palladium layer or the gold layer.

In the method for producing the conductive particle according to the first, second or third aspect of the present invention, the polymer electrolyte is preferably polyamines.

Polyamines is a high molecule that is ionized in an aqueous solution and have a functional group having electrical charges on its main chain or its side chain. The polyamines is strongly bonded on the surface of the palladium layer or the gold layer treated with an aqueous solution containing the polyamines, thus enabling the insulating particle to be strongly absorbed on the surface of the palladium layer or the gold layer with the polyamines therebetween.

In the method for producing the conductive particle according to the first, second or third aspect of the present invention, the polyamines is preferably polyethylenimine.

Because polyethylenimine has particularly high charge density and high bonding strength, the use of polyethylenimine facilitates absorption of the insulating particle more strongly on the surface of the palladium layer or the gold layer.

In the first, second or third aspect of the present invention, the insulating particle is preferably consisting of an inorganic oxide. If a fine particle consisting of an organic compound is used as the insulating particle, compared with the case where a fine particle consisting of an inorganic oxide is used, the insulating particle is likely to be deformed in the process of manufacturing an anisotropic conductive adhesive, and the advantageous effects of the present invention tend to be lowered. In the theromocompression bonding of the electrodes with the anisotropic conductive adhesive, if the insulating particle consisting of an organic compound melts to coat the surface of the conductive particle, the conductivity of the conductive particle (surface resistance) tends to be lowered. By contrast, if the insulating particle consisting of an inorganic oxide is used, such problems can be prevented.

In the first, second or third aspect of the present invention, the inorganic oxide is preferably silica. The insulating particle consisting of silica has high electrical insulation, its particle diameter is easily controllable, and it is economical. Furthermore, when silica is dispersed in water to make water-dispersed colloidal silica, the silica has a hydroxyl group on the surface thereof, thus having excellent bonding properties with the palladium layer or the gold layer. Furthermore, the hydroxyl group on the surface of silica has excellent bonding properties with the functional groups formed on the surface of the palladium layer or the gold layer. Accordingly, the insulating particle consisting of silica can be strongly absorbed on the surface of the palladium layer or the gold layer.

**Advantageous Effects of Invention**

According to the present invention, a conductive particle that causes no migration, requires low cost, has high conductivity, and provides excellent connection reliability between electrodes, and a method for producing such a conductive particle can be provided.

**Brief Description of Drawings**

[FIG 1] FIG 1 is a schematic cross-sectional view of a conductive particle according to a first embodiment of the present invention.

[FIG 2] FIG. 2 is a schematic cross-sectional view of a conductive particle according to a second embodiment of the present invention.

[FIG 3] FIG. 3 is a schematic cross-sectional view of a conductive particle according to a third embodiment of the present invention.

[FIG. 4] FIG. 4A is a schematic cross-sectional view of an anisotropic conductive adhesive containing such conductive particles according to the first embodiment of the present invention; and FIGS. 4B and 4C are schematic cross-sectional views illustrating a method for manufacturing a bonding structure using the anisotropic conductive adhesive.

**Reference Signs List**

| | |
|---|---|
| 1 | insulating particle |
| 2, 2a, 2b, 2c | mother particle |
| 3 | adhesive |
| 4 | first substrate |
| 5 | first electrode |
| 6 | second substrate |
| 7 | second electrode |
| 8, 8a, 8b, 8c | conductive particle |
| 11 | core particle |
| 12 | palladium layer |
| 13 | conductive layer |
| 14 | gold layer |
| 40 | anisotropic conductive adhesive |
| 42 | bonding structure |

**Description of Embodiments**

Preferred embodiments of the present invention will now be described in detail. The present invention, however, is not limited to these embodiments.

[First Embodiment]

(Conductive Particle)

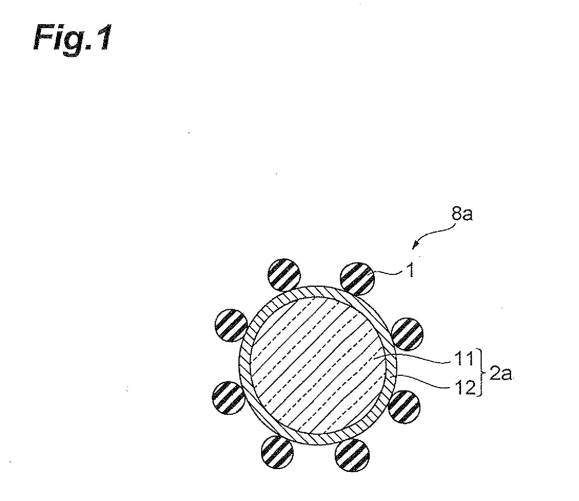

As illustrated in FIG. 1, a conductive particle 8a according to a first embodiment of the present invention comprises a core particle 11, a palladium layer 12 coating the core particle 11 and having a thickness of 200 Å or larger, and a plurality of insulating particles 1 arranged on the surface of the palladium layer 12 and having a particle diameter larger than the thickness of the palladium layer 12. In other words, in the conductive particle 8a, a part of the surface of a mother particle 2a comprising the core particle 11 and the palladium layer 12 coating the core particle 11 is covered with the insulating particles 1 acting as child particles.

<Mother Particle 2a>

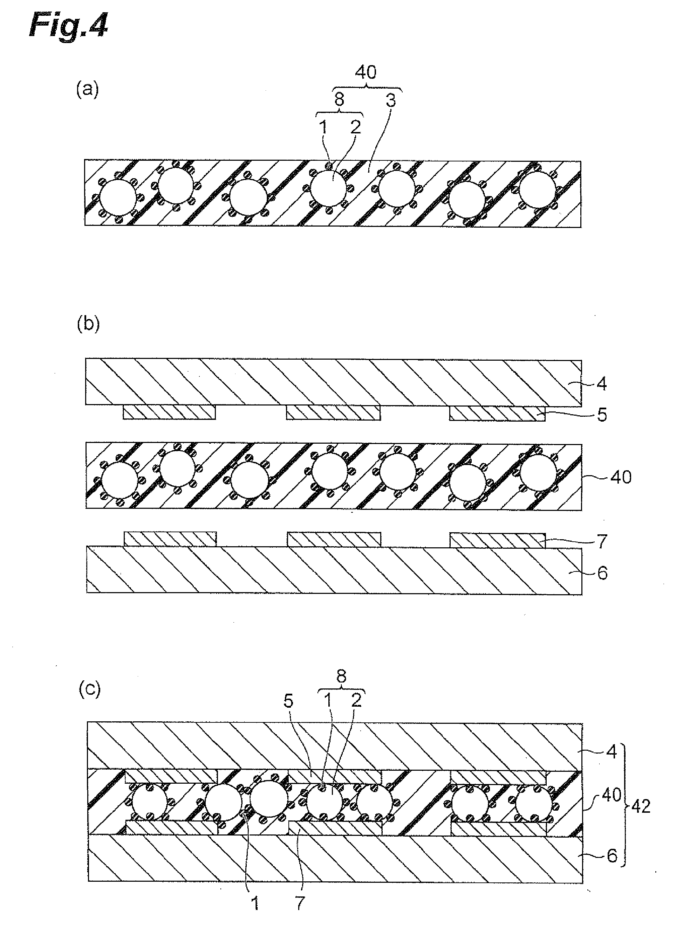

The particle diameter of the mother particle 2a used in the present invention is preferably smaller than the minimum distance between a first electrode 5 and a second electrode 7 in FIG 4 as described later. If the electrodes vary in height (distances between the electrodes), the particle diameter of the mother particle 2a is preferably larger than the variations of the height. For these reasons, the particle diameter of the mother particle 2a is preferably 1 to 10 $\mu$m, more preferably 1 to 5 $\mu$m, and particularly preferably 2 to 3.5 $\mu$m.

A mother particle in a conventional conductive particle is any of a particle consisting essentially of metal alone and a core particle of an organic substance or an inorganic substance coated with metal by a method such as plating. As for the mother particle 2a according to the present embodiment, the core particle 11 of an organic substance or an inorganic substance coated with metal by a method such as plating can be used. Furthermore, in the present embodiment, as for the mother particle 2a, the core particle of an organic substance coated with metal by a method such as plating is preferably used.

The core particle 11 of an organic substance is not particularly restricted, however, it is preferably a resin particle consisting of acrylic resin such as polymethylmethacrylate and polymethylacrylate, polyolefin resin such as polyethylene, polypropylene, polyisobutylene, and polybutadiene, or the like.

Because the palladium layer 12 has ductility, it is hard to cause metal cracking after the conductive particle 8a is compressed, as well as migration along with the metal cracking. Furthermore, because the palladium layer 12 has an excellent resistance to acids and alkalis compared with base metal or copper, it is stably bonded with a later-described functional group such as a mercapto group, a sulfide group and a disulfide group. Furthermore, palladium has the same tendency in bonding properties with the functional groups as gold and platinum, however, when comparing these noble metals in the same volume, palladium is the most economical and practically applicable. In addition, the palladium layer 12 has high conductivity. For these reasons, the palladium layer 12 is suitable for a metal layer to coat the core particle 11.

The palladium layer 12 may be composed of alloy of palladium and phosphorus. When the palladium layer 12 is consisting of alloy, in terms of conductivity, the content of palladium in the alloy is preferably 70% by weight or more, and more preferably 90% by weight or more and less than 100% by weight.

The palladium layer 12 is preferably a reduction plating type palladium layer. With such a palladium layer, the coverage of the palladium layer 12 with respect to the core particle 11 is enhanced and the conductivity of the conductive particle 8a is further enhanced.

The thickness of the palladium layer 12 is preferably 200 Å or larger and 1000 Å or smaller. If the thickness of the palladium layer is smaller than 200 Å, sufficient conductivity can not be provided. By contrast, if the thickness of the palladium layer 12 exceeds 1000 Å, the elasticity of the whole mother particle 2a tends to be lowered. In the case where the elasticity of the whole mother particle 2a is lowered, when the conductive particle 8a is sandwiched and crushed in a vertical direction with a pair of electrodes, the palladium layer 12 is difficult to be pushed against the surface of the electrodes sufficiently due to the elasticity of the mother particle 2a. As a result, the area of contact between the palladium layer 12 and both of the electrodes becomes small, and the advantageous effects of the present invention to enhance connection reliability between the electrodes tend to be lowered. In addition, the larger thickness the palladium layer 12 has, the higher the cost becomes, which is disadvantageous in terms of economy.

<Insulating Particle 1>

The insulating particle 1 is preferably consisting of an inorganic oxide. If the insulating particle 1 is an organic compound, it is deformed in the process of manufacturing an anisotropic conductive adhesive, and the characteristics of the anisotropic conductive adhesive prepared tend to be changed.

The inorganic oxide constituting the insulating particle 1 is preferably an oxide containing at least one element selected from the group consisting of silicon, aluminum, zirconium, titanium, niobium, zinc, tin, cerium and magnesium. These oxides can be used alone or two or more oxides can be used in combination. Among the oxides containing the above elements, the inorganic oxide is most preferably water-dispersed colloidal silica ($SiO_2$) that has high electrical insulation and a controlled particle diameter.

Examples of marketed products of the insulating particle of such inorganic oxides (hereinafter, referred to as an inorganic oxide fine particle) include SNOWTEX and SNOWTEX UP (available from Nissan Chemical Industries, Ltd.) and Quartron PL series (available from Fuso Chemical Co., Ltd.).

The particle diameter of the inorganic oxide fine particle is preferably 20 to 500 nm, which is measured by specific surface area reduction by the BET method, or small angle X-ray scattering. If the particle diameter thereof is smaller than 20 nm, the inorganic oxide fine particles absorbed on the mother particle 2a fail to act as an insulating film, which tends to cause short circuit between a part of the electrodes. By contrast, if the particle diameter of the inorganic oxide fine particles exceeds 500 nm, conductivity between the electrodes is not likely to be achieved.

(Method for Producing the Conductive Particle 8a)

A method for producing the conductive particle 8a according to the first embodiment of the present invention comprises forming the palladium layer 12 on the surface of the core particle 11 (S1), forming functional groups on the surface of the palladium layer 12 by treating the surface of the palladium layer 12 with a compound containing any of a mercapto group, a sulfide group and a disulfide group (S2), treating the surface of the palladium layer provided with the functional groups with a polymer electrolyte (S3), and immobilizing the insulating particles 1 by chemisorption on the surface of the palladium layer 12 provided with the functional groups and treated with the polymer electrolyte (S4). A description will be given of the case where the insulating particle 1 is an inorganic oxide fine particle provided with a hydroxyl group on the surface thereof.

<S1>

To begin with, the palladium layer 12 is formed on the surface of the core particle 11 to prepare the mother particle 2a. Specific methods thereof, for example, include plating with palladium. The plating process is preferably executed such that a palladium catalyst is added first, and then reduction type electroless palladium plating is performed. The composition of the reduction type electroless palladium plating is preferably added with (1) water-soluble palladium salt such as palladium sulfate, (2) reducing agent, (3) complexing agent and (4) pH adjuster.

<S2>

Next, the surface of the palladium layer 12 is treated with the compound containing any of a mercapto group, a sulfide group and a disulfide group that forms a coordinate bond to palladium. In this manner, the functional groups are formed on the surface of the palladium layer 12.
The compounds used for treating of the surface of the palladium layer 12 specifically include mercaptoacetic acid, 2-mercaptoethanol, methyl mercaptoacetate, mercaptosuccinic acid, thioglycerin and cysteine. The functional groups formed on the surface of the palladium layer 12 treated with these compounds include a hydroxyl group, a carboxyl group, an alkoxyl group and an alkoxycarbonyl group.
Palladium readily reacts with a thiol group (mercapto group), whereas a base metal such as nickel is hard to react therewith. Accordingly, a palladium particle (core particle 11 coated with the palladium layer 12) according to the present embodiment readily reacts with a thiol group compared with a conventional nickel/gold particle (core particle coated with a nickel layer or a gold layer). Particularly, when the thickness of gold in the nickel/gold particle is 300 Å or smaller, the proportion of nickel on the surface of the particle tends to be increased.
Specific methods for treating the surface of the palladium layer 12 with the compound described above include, for example, a method in which palladium particles are dispersed in a liquid prepared by dispersing a compound such as mercaptoacetic acid approximately in an amount of 10 to 100 mmol/l in an organic solvent such as methanol and ethanol.

<S3,S4>

Next, the surface of the palladium layer 12 provided with the functional groups is treated with the polymer electrolyte, and then the insulating particles 1 are chemisorbed on the surface of the palladium layer 12.
The surface potential (zeta potential) of the palladium layer 12 having the functional groups such as a hydroxyl group, a carboxyl group, an alkoxyl group or an alkoxycarbonyl group is generally negative at a neutral pH range. On the other hand, because the surface of the insulating particle 1 to be absorbed on the surface of the palladium layer 12 in a later-described process is consisting of an inorganic oxide having a hydroxyl group, the surface potential of the insulating particle 1 is generally negative as well. Therefore, the insulating particle 1 having the negative surface potential tends to be difficult to be absorbed on the circumference of the palladium layer 12 having the negative surface potential. Accordingly, by treating the surface of the palladium layer 12 with the polymer electrolyte, the surface of the palladium layer 12 is readily covered with the insulating particles 1.
The method for causing the insulating particles 1 to be absorbed on the surface of the palladium layer 12 treated with the polymer electrolyte is preferably such that polymer electrolyte and inorganic oxides are layered alternately on the surface of the palladium layer 12. More specifically, by performing steps (1) and (2) below successively, the mother particle 2a, a part of whose surface is covered with an insulating coating film having polymer electrolyte and inorganic oxides fine particles layered, that is, the conductive particle 8a can be produced.
Step (1): The mother particles 2a having the functional groups on the surface of the palladium layer 12 are dispersed in a polymer electrolyte solution to cause the polymer electrolyte to be absorbed on the surface of the palladium layer 12, and then the mother particles 2a are rinsed.

Step (2): The mother particles 2a rinsed are dispersed in a dispersed solution of the inorganic oxide fine particles to cause the inorganic oxide fine particles to be absorbed on the surface (palladium layer 12) of the mother particles 2a, and then the mother particles 2a are rinsed.

In other words, in step (1), a polymer electrolyte thin film is formed on the surface of the mother particle 2a, and in step (2), the inorganic oxide fine particles are immobilized by chemisorption on the surface of the mother particle 2a with the polymer electrolyte thin film interposed therebetween. With the polymer electrolyte thin film, the surface of the mother particle 2a can be uniformly covered with the inorganic oxide fine particles without any defect. By using an anisotropic conductive adhesive containing the conductive particles prepared through such steps (1) and (2) to connect circuit electrodes, electrical insulation is maintained even if the pitches between the circuit electrodes are narrow. By contrast, connection resistance becomes lowered and excellent between the electrodes electrically connected to each other.

The method comprising steps (1) and (2) is referred to as the Layer-by-Layer assembly method. The Layer-by-Layer assembly is a method for forming an organic thin film introduced by G. Lecher and others in 1992 (see Thin Solid Films, 210/211, p831 (1992)).

In the Layer-by-Layer assembly method, by soaking a substrate alternately in an aqueous solution of polymer electrolyte (polycation) having a positive charge and in an aqueous solution of polymer electrolyte (polyanion) having a negative charge, sets of polycation and polyanion absorbed on the substrate by electrostatic attraction are layered to provide a composite film (Layer-by-Layer film).

In the Layer-by-Layer assembly method, because the charge of a material formed on a substrate and a material having the opposite charge in an aqueous solution are attracted to each other by electrostatic attraction to promote a film growth, when the absorption proceeds to cause charge neutralization, further absorption does not occur. Therefore, if the reaction reaches a certain saturation point, the thickness of the film does not increase any more.

Lvov and others applied the Layer-by-Layer assembly method to fine particles and reported a method in which polymer electrolyte having the charge opposite to the surface charge of a fine particle is layered by the Layer-by-Layer assembly method using dispersed solutions of respective fine particles of silica, titania and ceria (see, Langmuir, Vol. 13, (1997) pp. 6195-6203).

With the method, by layering silica fine particles having the negative surface charge and poly diallyldimethylammonium chloride (PDDA) or polyethylenimine (PEI) acting as polycation having the charge opposite thereto alternately, a fine particle layered thin film in which silica fine particles and polymer electrolyte are layered alternately can be formed.

In the present embodiment, it is preferable that, after the mother particle 2a is soaked in the polymer electrolyte solution or the dispersed solution of the inorganic oxide fine particles, the surplus polymer electrolyte solution or dispersed solution of the inorganic oxide fine particles be rinsed off from the mother particle 2a with a solvent alone, and then the mother particle 2a be soaked in the polymer electrolyte solution or the dispersed solution of the inorganic oxide fine particles having the charge opposite to the foregoing.

Because the polymer electrolyte and the inorganic oxide fine particles thus absorbed on the mother particle 2a are absorbed on the surface of the mother particle 2a electrostatically, they are not separated from the surface of the mother particle 2a in this rinsing step. If the surplus polymer electrolyte or inorganic oxide fine particles not being absorbed on the mother particle 2a are put into a solution having the charge opposite thereto, however, cations and anions are mixed together and aggregation and precipitation of the polymer electrolyte or the inorganic oxide fine particles may occur in the solution. The rinsing step can prevent such problems from occurring.

Solvents used for the rinsing step include water, alcohol or acetone, however, ion exchange water (so-called super pure water) having a specific resistance value of 18 MΩcm or more is generally used because it readily removes the surplus polymer electrolyte solution or dispersed solution of the inorganic oxide fine particles.

The polymer electrolyte solution is the solution prepared by dissolving polymer electrolyte in water or a mixed solvent of water and a water-soluble organic solvent. Applicable water-soluble organic solvents include, for example, methanol, ethanol, propanol, acetone, dimethylformamide and acetonitrile.

As for the polymer electrolyte, a high molecule that has a functional group ionizing in an aqueous solution and having an electrical charge on its main chain or its side chain can be used. In this case, polycation is suitably used.

Polycation having a functional group that is able to have a positive charge, such as polyamines, can be used generally, which includes polyethylenimine (PEI), polyallylamine hydrochloride (PAH), poly diallyldimethylammonium chloride (PDDA), polyvinylpyridine (PVP), polylysine, polyacrylamide and a copolymer containing at least one type thereof, for example.

Among the polymer electrolyte, polyethylenimine has high charge density and high bonding strength. To prevent electromigration and corrosion, the polymer electrolyte that contains no alkali metal (Li, Na, K, Rb and Cs) ions, no alkaline-earth metal (Ca, Sr, Ba and Ra) ions and no halide ions (fluorine ion, chloride ion, bromine ion and iodine ion) is preferably used.

These polymer electrolytes are soluble in water or a mixture of water and an organic solvent. The molecular weight of the polymer electrolyte, which cannot be flatly specified depending on the type thereof to be used, is preferably about 500 to 200,000 generally. The concentration of the polymer electrolyte in the solution is preferably about 0.01 to 10% by weight generally. The pH of the polymer electrolyte solution is not particularly restricted.

By adjusting the type, molecular weight, and concentration of the polymer electrolyte thin film coating the mother particle 2a, the coverage of the inorganic oxide fine particles can be controlled.

More specifically, in the case where a polymer electrolyte thin film with high charge density, such as polyethylenimine, is used, the coverage of the inorganic oxide fine particles tends to be high, whereas in the case where a polymer electrolyte thin film with low charge density, such as poly diallyldimethylammonium chloride, is used, the coverage of the inorganic oxide fine particles tends to be low.

In the case where the molecular weight of the polymer electrolyte is large, the coverage of the inorganic oxide fine particles tends to be high and thus the inorganic oxide fine particles can be strongly absorbed on the palladium layer 12. In terms of the bonding strength, the molecular weight of the polymer electrolyte is preferably 10,000 or more. By contrast, in the case where the molecular weight of the polymer electrolyte is small, the coverage of the inorganic oxide fine particles tends to be low.

In the case where the polymer electrolyte is used in high concentration, the coverage of the inorganic oxide fine particles tends to be high, whereas in the case where the polymer electrolyte is used in low concentration, the coverage thereof tends to be low. The high coverage of the inorganic oxide fine particles tends to provide high electrical insulation and low conductivity, whereas the low coverage of the inorganic oxide fine particles tends to provide high conductivity and low electrical insulation.

A plurality of inorganic oxide fine particles preferably form a single layer which covers a metal layer. If they form stacked layers, the amount of the stacked layers is difficult to control. The coverage of the inorganic oxide fine particles is preferably in a range of 20 to 100%, and more preferably in a range of 30 to 60%.

The concentration of alkali metal ions and alkaline-earth metal ions in the dispersed solution of the inorganic oxide fine particles is preferable 100 ppm or less. In this manner, insulation reliability between adjacent electrodes is readily enhanced. The inorganic oxide fine particle prepared by hydrolysis reaction of metal alkoxide, so-called sol-gel method, is suitably used.

Particularly, water-dispersed colloidal silica ($SiO_2$) is suitably used for the inorganic oxide fine particle. Because water-dispersed colloidal silica has a hydroxyl group on the surface thereof, it is preferably used for the inorganic oxide fine particle in terms of its excellent bonding properties with the mother particle 2a, its particle diameter that is easily controllable, and its economical advantage.

A hydroxyl group is generally known for forming a strong bond with a hydroxyl group, a carboxyl group, an alkoxyl group and an alkoxycarbonyl group. Specific manners of the bond between the hydroxyl group and these functional groups include a covalent bond by dehydration condensation or a hydrogen bond. Accordingly, the inorganic oxide fine particles having a hydroxyl group on the surface thereof can be strongly absorbed on the palladium layer 12 (surface of the mother particle 2a) provided with functional groups such as a hydroxyl group, a carboxyl group, an alkoxyl group and an alkoxycarbonyl group.

The hydroxyl group on the surface of the inorganic oxide fine particle can be denatured to an amino group, a carboxyl group, or an epoxy group with a silane coupling agent or the like, however, if the particle diameter of the inorganic oxide is 500 nm or smaller, the denaturation is difficult to perform. Therefore, it is preferable that the mother particle 2a be covered with the inorganic oxide fine particles without denaturing of the functional groups.

By heating and drying the conductive particle 8a thus prepared, the bond between the insulating particles 1 and the mother particle 2a can be further enhanced. Reasons for the enhancement of the bonding strength include, for example, promoting a chemical bond between the functional groups, such as carboxyl groups, on the surface of the palladium layer 12 and the hydroxyl groups on the surfaces of the insulating particles 1, or promoting dehydration condensation of the carboxyl groups on the surface of the palladium layer 12 and amino groups on the surfaces of the insulating particles 1. Heating is preferably performed in a vacuum in terms of rust prevention for metals. As in a later-described third embodiment, even if the outermost surface of a mother particle is a gold layer, in a similar manner to that of the palladium layer 12, the bond between insulating particles and a mother particle can be further enhanced by heating and drying.

The temperature of heating and drying is preferably 60 to 200 degrees C, and the time thereof is preferably 10 to 180 minutes. In the case where the temperature is lower than 60 degrees C or the heating time is shorter than 10 minutes, the insulating particles 1 are likely to be separated from the mother particle 2a, whereas in the case where the temperature exceeds 200 degrees C or the heating time is longer than 180 minutes, the mother particle 2a is likely to be deformed. Those cases are not preferable.

(Anisotropic Conductive Adhesive)

As illustrated in FIG 4A, the conductive particles 8a thus prepared are dispersed in an adhesive 3 to provide an anisotropic conductive adhesive 40. A method for manufacturing a bonding structure 42 using the anisotropic conductive adhesive 40 is illustrated in FIGS. 4B and 4C. In FIG 4, the palladium layer 12 provided to a conductive particle 8 is omitted for simplification of the drawings.

As illustrated in FIG. 4B, a first substrate 4 and a second substrate 6 are prepared with the anisotropic conductive adhesive 40 applied therebetween. In this process, the first electrodes 5 provided to the first substrate 4 and the second electrodes 7 provided to the second substrate 6 are arranged to face each other. The first substrate 4 and the second substrate 6 are then applied heat and pressure in a direction in which the first electrodes 5 and the second electrodes 7 face each other, and layered to provide the bonding structure 42 illustrated in FIG 4C.

By manufacturing the bonding structure 42 in this manner, the insulating particles 1 dent into corresponding mother particles 2 to cause the first electrodes 5 and the second electrodes 7 to become electrically conductive via the surfaces (palladium layer) of the mother particles 2 in a vertical direction, and the insulating particles 1 are interposed between the mother particles to maintain electrical insulation in a horizontal direction.

An anisotropic conductive adhesive for COG requires for insulation reliability in narrow pitches of 10-$\mu$m level recently. By using the anisotropic conductive adhesive 40 according to the present embodiment, insulation reliability in narrow pitches of 10-$\mu$m level can be enhanced.

As for the adhesive for the anisotropic conductive adhesive 40, a mixture of thermo-reactive resin and a curing agent is used. More specifically, a mixture of epoxy resin and a latent curing agent is preferably used.

As for the epoxy resin, bisphenol type epoxy resin induced from epichlorohydrin and bisphenol-A, F, AD or the like, epoxy novolac resin induced from epichlorohydrin, and phenol novolac or cresol novolac, naphthalene based epoxy resin with a skeleton containing a naphthalene ring, various types of epoxy compounds of glycidyl amine, glycidyl ether biphenyl, and alicyclic having two or more glycidyl groups in one molecule or the like can be used alone, or two or more compounds can be used in combination.

The high-purity epoxy resin in which impurity ions (e.g., Na$^+$, Cl$^-$), hydrolyzable chlorine, or the like is reduced to 300 ppm or less is preferably used. With such epoxy resin, electromigration is readily prevented.

The latent curing agents include imidazole, hydrazide, boron trifluoride-amine complex, sulfonium salt, amine imide, polyamine salt and dicyandiamide. In addition to these agents, a mixture of radical reactive resin and an organic peroxide, or energy-ray curable resin cured by ultraviolet rays or the like is used for the adhesive.

To reduce stress after being adhered, or to enhance adhesiveness, the adhesive 3 can be mixed with butadiene rubber, acrylic rubber, styrene-butadiene rubber, silicone rubber, or the like.

The adhesive 3 is used in a paste form or a film form. To prepare a film adhesive, it is effective to mix thermoplastic resin, such as phenoxy resin, polyester resin and polyamide resin to the adhesive. These film formation polymers are also effective for alleviation of stress in curing a reactive resin. Particularly, the film formation polymer having a functional group such as a hydroxyl group is preferably used in terms of enhancement of adhesiveness.

The film is formed by: dissolving or dispersing adhesive compositions composed of epoxy resin, acrylic rubber, a latent curing agent, and film formation polymers in an organic solvent to prepare a solution or dispersion thereof; applying the solution or dispersion on a release base material; and removing the solvent at or below the activation temperature of the curing agent. A mixture of an aromatic hydrocarbon solvent and an oxygenated solvent is preferably used for the organic solvent in this process in terms of enhancement of the material solubility.

The thickness of the anisotropic conductive adhesive 40, which is relatively determined in consideration of the particle diameter of the conductive particle 8 and characteristics of the anisotropic conductive adhesive 40, is preferably 1 to 100 $\mu$m, If it is smaller than 1 $\mu$m, sufficient adhesiveness cannot be provided, whereas if it exceeds 100 $\mu$m, a lot of conductive particles are required to provide conductivity, which is not practically applicable. For these reasons, the thickness thereof is more preferably 3 to 50 $\mu$m.

The first substrate 4 or the second substrate 6 include a glass substrate, a tape substrate such as polyimide, a bare chip such as a driver IC, and a rigid package substrate.

[Second Embodiment]

Next, a conductive particle and a method for producing a conductive particle according to a second embodiment of the present invention will be described. It is noted that differences between the first embodiment and the second embodiment are merely described below, and descriptions of matters common to the both will be omitted.

(Conductive Particle)

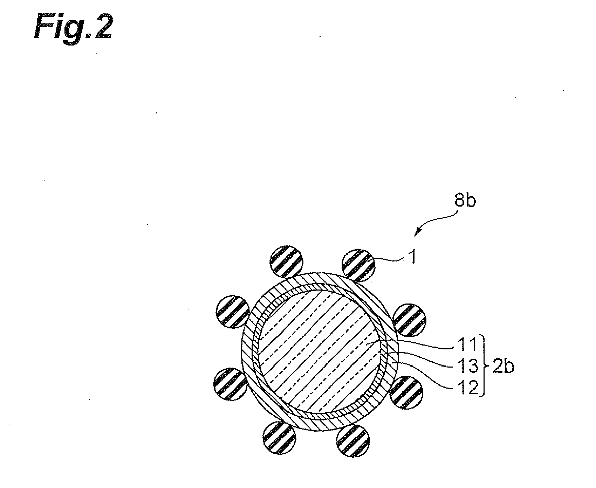

As illustrated in FIG. 2, a conductive particle 8b according to the second embodiment is different from the conductive particle 8a according to the first embodiment such that the conductive particle 8b further comprises a conductive layer 13 between a core particle 11 and a palladium layer 12.

Specifically, the conductive particle 8b according to the second embodiment of the present invention comprises the core particle 11, the conductive layer 13 coating the core particle 11, the palladium layer 12 coating the conductive layer 13 and having a thickness of 200 Å or larger, and a plurality of insulating particles 1 arranged on the surface of the palladium layer 12 and having a particle diameter larger than the sum of the thicknesses of the conductive layer 13 and the palladium layer 12. In other words, in the conductive particle 8b, a part of the surface of a mother particle 2b comprising the core particle 11, and the conductive layer 13 and the palladium layer 12 coating the core particle 11, is covered with the insulating particles 1 acting as child particles.

The conductive particle 8b according to the second embodiment, in a similar manner to the conductive particle 8a according to the first embodiment, causes no migration, requires low cost, has high conductivity, and provides excellent connection reliability between electrodes. In the second embodiment, by including the conductive layer 13 consisting of a base metal, copper or the like that is economical and has high conductivity, it is possible to reduce cost of the conductive particle 8b and to enhance the conductivity thereof. Furthermore, in the second embodiment, because the conductive layer 13 is coated with the palladium layer 12, the palladium layer 12 functions as a migration stop layer with respect to the conductive layer 13.

The conductive layer 13 includes a layer consisting of metals such as gold, silver, copper, platinum, zinc, iron, palladium, nickel, tin, chromium, titanium, aluminum, cobalt, germanium and cadmium, or a layer consisting of a metal compound such as ITO or solder. Among such layers, the conductive layer 13 is preferably a layer consisting of nickel. By comprising the conductive layer consisting of nickel, which is economical and has high conductivity, it is possible to further reduce cost of the conductive particle and to enhance the conductivity thereof.

(Method for Producing the Conductive Particle 8b)

A method for producing the conductive particle 8b according to the second embodiment of the present invention comprises forming the conductive layer 13 on the surface of the core particle 11, forming the palladium layer 12 on the surface of the conductive layer 13, forming functional groups on the surface of the palladium layer 12 by treating the surface of the palladium layer 12 with a compound containing any of a mercapto group, a sulfide group and a disulfide group, and immobilizing the insulating particles 1 by chemisorption on the surface of the palladium layer 12 provided with the functional groups.

In the second embodiment, in a similar manner to the first embodiment, it is preferable that the surface of the palladium layer 12 provided with the functional groups be treated with a polymer electrolyte, and then the insulating particles 1 be absorbed on the surface of the palladium layer 12.

[Third Embodiment]

Next, a conductive particle and a method for producing a conductive particle according to a third embodiment of the present invention will be described. It is noted that differences between the first embodiment and the third embodiment are merely described below, and descriptions of matters common to the both will be omitted.

(Conductive Particle)

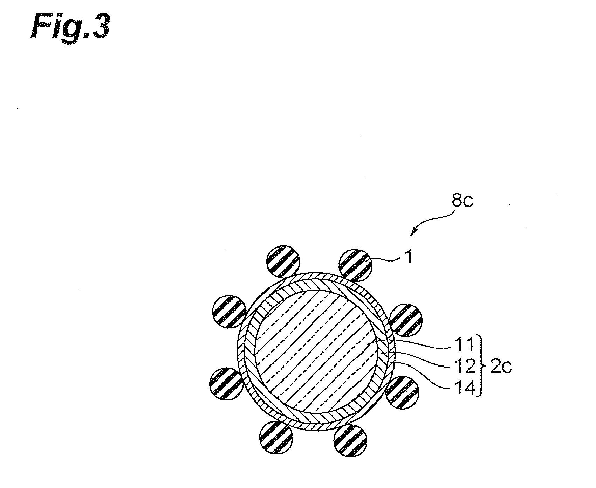

As illustrated in FIG 3, a conductive particle 8c according to the third embodiment is different from the conductive particle 8a according to the first embodiment such that a gold layer 14 coats the surface of a palladium layer 12 coating a core particle 11.

Specifically, the conductive particle 8c according to the third embodiment of the present invention comprises the core particle 11, the palladium layer 12 coating the core particle 11 and having a thickness of 200 Å or larger, the gold layer 14 coating the palladium layer 12, and a plurality of insulating particles 1 arranged on the surface of the gold layer 14 and having a particle diameter larger than the sum of the thicknesses of the palladium layer 12 and the gold layer 14. In other words, in the conductive particle 8c, a part of the surface of a mother particle 2c comprising the core particle 11, and the palladium layer 12 and the gold layer 14 coating the core particle 11 is covered with the insulating particles 1 acting as child particles.

The conductive particle 8c according to the third embodiment, in a similar manner to the conductive particle 8a according to the first embodiment, causes no migration, requires low cost, has high conductivity, and provides excellent connection reliability between electrodes. In the third embodiment, by comprising the gold layer 14 as the outermost layer of the mother particle 2c, it is possible to lower the surface resistance of the mother particle 2c and to enhance the conductivity of the whole conductive particle 8c. The conductive particle 8c according to the third embodiment may further comprise a conductive layer similar to that of the second embodiment between the core particle 11 and the palladium layer 12.

(Method for Producing the Conductive Particle 8c)

A method for producing the conductive particle 8c according to the third embodiment or the present invention comprises forming the palladium layer 12 on the surface of the core particle 11, forming the gold layer 14 on the surface of the palladium layer 12, forming functional groups on the surface of the gold layer 14 by treating the surface of the gold layer 14 with a compound containing any of a mercapto group, a sulfide group and a disulfide group, and immobilizing the insulating particles 1 by chemisorption on the surface of the gold layer 14 provided with the functional groups.

In the third embodiment, in a similar manner to the first embodiment, it is preferable that the surface of the gold layer 14 provided with the functional groups be treated with a polymer electrolyte, and then the insulating particles 1 be absorbed on the surface of the gold layer 14.

Specific methods for forming the gold layer 14 on the surface of the palladium layer 12 include, for example, plating with gold. As for the gold plating, displacement type gold plating such as HGS-100 (available from Hitachi Chemical Co., Ltd., brand name), or reduction type electroless gold plating such as HGS-2000 (available from Hitachi Chemical Co., Ltd., brand name) can be used. The reduction type electroless gold plating is preferably used because the coverage thereof is readily enhanced.

Gold readily reacts with a thiol group (mercapto group), whereas a base metal such as nickel is hard to react therewith. Accordingly, a gold particle (core particle 11 coated with the palladium layer 12 and the gold layer 14) according to the present embodiment readily reacts with a thiol group compared with a comventional nickel/gold particle (core particle coated with a nickel layer and a gold layer). Particularly, when the thickness of gold in a nickel/gold particle is 300 Å or smaller, the proportion of nickel on the surface of the particle tends to be increased.

In consideration of a balance between a decrease in surface resistance and an increase in cost, the thickness of the gold plating may be set according to the circumstances. The thickness of the gold plating is preferable 300 Å or smaller, however, even if it exceeds 300 Å, no problem occurs in the characteristics.

**Examples**

The present invention will be described with examples below.

(Mother Particle 1)

One gram of cross-linked polystyrene particles (resin fine particles) having an average particle diameter of 3.8 μm was added to 100 mL of a palladium catalyzing solution containing Atotech Neoganth 834 (available from Atotech Japan Co., Ltd., brand name), acting as a palladium catalyst, in an amount of 8% by weight, stirred at 30 degrees C for 30 minutes, filtered out by a membrane filter having a pore diameter of 3 μm (available from Millipore Corporation), and then washed with water.

Next, the resin fine particles washed with water were added to a 0.5%-by-weight dimethylamine-borane solution having an adjusted pH of 6.0, and resin fine particles (resin core particles) with activated surfaces were prepared. The resin fine particles with the activated surfaces were then soaked in distilled water and dispersed by ultrasonic waves.

The solution described above was filtered by a membrane filter having a pore diameter of 3 μm (available from Millipore Corporation), the resin fine particles with the activated surfaces were soaked in APP (available form Ishihara Chemical Co., Ltd., brand name) acting as an electroless palladium plating solution under a condition of 50 degrees C, and electroless Pd plating was performed on the surface of the resin to a thickness of 600 Å.

Subsequently, the particles were filtered out by a membrane filter having a pore diameter of 3 μm (available from Millipore Corporation), washed with water, and then dried. Thus, mother particles 1 having a Pd layer with a thickness of 600 Å on the surface of the resin core particles thereof were produced.

(Mother Particle 2)

By the same method as that for the mother particles 1 except that the mother particles 1 were soaked in HGS-2000 (available from Hitachi Chemical Co., Ltd., brand name) acting as reduction type electroless gold plating under a condition of 65 degrees C to add a gold layer with a thickness of 100 Å, mother particles 2 having a Pd layer with a thickness of 600 Å and an Au layer with a thickness of 100 Å on the surface of the resin core particles thereof were produced.

(Mother Particle 3)

While a suspension of fine particles yet to be treated with an electroless palladium plating solution was stirred at 50 degrees C, an electroless plating solution A having an adjusted pH of 7.5 and composed of 50 g/L of nickel sulfate hexahydrate, 20 g/L of sodium hypophosphite monohydrate, 2.5 g/L of dimethylamine-borane, and 50 g/L of citric acid was gradually added thereto, and thus electroless nickel plating was performed on the resin fine particles.

The nickel film thickness was adjusted by sampling and atomic absorption, and the addition of the electroless plating solution A was stopped once the nickel film thickness reached 300 Å. After being filtered out, the resin fine particles were washed with 100 ml of pure water for 60 seconds, and then particles having a nickel film with a thickness of 300 Å on the surface thereof were produced. By the same method as that for the mother particles 1 except for the matters above, mother particles 3 having a Ni layer with a thickness of 300 Å and a Pd layer with a thickness of 600 Å on the surface of the resin core particles thereof were produced.

(Mother Particle 4)

By the same method as that for the mother particles 3 except that the thickness of a Pd plating layer was 200 Å, mother particles 4 having a Ni layer with a thickness of 300 Å and a Pd layer with a thickness of 200 Å on the surface of the resin core particles thereof were produced.

(Mother Particle 5)

One gram of cross-linked polystyrene particles (resin fine particles) having an average particle diameter of 3.8 $\mu$m was added to 100 mL of a palladium catalyzing solution containing Atotech Neoganth 834 (available from Atotech Japan Co., Ltd., brand name), acting as a palladium catalyst, in an amount of 8 % by weight, stirred at 30 degrees C for 30 minutes, filtered out by a membrane filter having a pore diameter of 3 $\mu$m (available from Millipore Corporation), and then washed with water.

Next, the resin fine particles washed with water were added to a 0.5 %-by-weight dimethylamine-borane solution having an adjusted pH of 6.0, and resin fine particles with activated surfaces were prepared. The resin fine particles with the activated surfaces were then soaked in distilled water and dispersed by ultrasonic waves.

The solution described above was filtered by a membrane filter having a pore diameter of 3 $\mu$m (available from Millipore Corporation) and stirred at 50 degrees C. An electroless plating solution A having an adjusted pH of 7.5 and composed of 50 g/L of nickel sulfate hexahydrate, 20 g/L of sodium hypophosphite monohydrate, 2.5 g/L of dimethylamine-borane, and 50 g/L of citric acid was gradually added thereto, and thus electroless nickel plating was performed on the resin fine particles.

The nickel film thickness was adjusted by sampling and atomic absorption, and the addition of the electroless plating solution A was stopped once the nickel film thickness reached 700 Å. After being filtered out, the resin fine particles were washed with 100 ml of pure water for 60 seconds, and thus particles having a nickel film with a thickness of 700 Å on the surface thereof were produced.

The particles were then soaked in HGS-2000 (available from Hitachi Chemical Co., Ltd., brand name) acting as reduced electroless gold plating under a condition of 65 degrees C, and a gold layer with a thickness of 300 Å was formed thereon by plating. With this process, mother particles 5 having a Ni layer with a thickness of 700 Å and an Au layer with a thickness of 300 Å on the surface of the resin core particles thereof were produced.

(Mother Particle 6)

After a nickel film was formed on the surface of resin fine particles, the resin fine particles with activated surfaces were soaked in APP (available form Ishihara Chemical Co., Ltd., brand name) acting as an electroless palladium plating solution under a condition of 50 degrees C, and electroless Pd plating was performed on the surface of the resin to a thickness of 180 Å. With this process, mother particles 6 having a Ni layer with a thickness of 700 Å and a Pd layer with a thickness of 180 Å on the surface of the resin core particles thereof were produced.

Next, conductive particles 1 to 6 were produced using the mother particles 1 to 6 prepared above.

(Conductive Particle 1)

To prepare a reaction solution, 8 mmol of mercaptoacetic acid was dissolved in 200 ml of methanol.

One gram of the mother particles 1 was then added to the reaction solution, and stirred at room temperature (25 degrees C) for 2 hours by a three-one motor and stirring blades with a diameter of 45 mm. After being washed with methanol, the mother particles 1 were filtered out by a membrane filter having a pore diameter of 3 $\mu$m (available from

Millipore Corporation), and thus the mother particles 1 having a carboxyl group on the surface thereof were produced.

Thirty-percent polyethyleneimine aqueous solution with a molecular weight of 70000 (available from Wako Pure Chemical Industries, Ltd.) was diluted with super pure water to prepare a 0.3%-by-weight polyethyleneimine aqueous solution. One gram of the mother particles 1 having the carboxyl group was added to the 0.3%-by-weight polyethyleneimine aqueous solution and stirred at room temperature for 15 minutes.

The mother particles 1 were then filtered out by a membrane filter having a pore diameter of 3 $\mu$m (available from Millipore Corporation), added to 200 g of super pure water, and stirred at room temperature for 5 minutes. The mother particles 1 were further filtered out by a membrane filter having a pore diameter of 3 $\mu$m (available from Millipore Corporation), and washed with 200 g of super pure water on the membrane filter twice. Thus, polyethyleneimine not being absorbed on the mother particles 1 was removed.

Next, a dispersed solution of colloidal silica acting as insulating particles (mass concentration of 20%, available from Fuso Chemical Co., Ltd., brand name: Quartron PL-10, average particle diameter of 100 nm) was diluted with super pure water to prepare a 0.1%-by-weight silica dispersed solution. The mother particles 1 treated with polyethyleneimine were added to the 0.1%-by-weight silica dispersed solution, and stirred at room temperature for 15 minutes.

The mother particles 1 were then filtered out by a membrane filter having a pore diameter of 3 $\mu$m (available from Millipore Corporation), added to 200 g of super pure water, and stirred at room temperature for 5 minutes. The mother particles 1 were further filtered out by a membrane filter having a pore diameter of 3 $\mu$m (available from Millipore Corporation), and washed with 200 g of super pure water on the membrane filter twice. Thus, silica not being absorbed on the mother particles 1 was removed. The mother particles 1 were then dried under a condition of 80 degrees C for 30 minutes, and heated and dried at 120 degrees C for 1 hour. Thus, the conductive particles 1 with silica (child particles) absorbed on the surface of the mother particles 1 were produced.

(Conductive Particle 2)

The conductive particles 2 were produced by the same method as that for the conductive particles 1 except for using the mother particles 2 instead of the mother particles 1.

(Conductive Particle 3)

The conductive particles 3 were produced by the same method as that for the conductive particles 1 except for using the mother particles 3 instead of the mother particles 1.

(Conductive Particle 4)

The conductive particles 4 were produced by the same method as that for the conductive particles 1 except for using the mother particles 4 instead of the mother particles 1.

(Conductive Particle 5)

The conductive particles 5 were produced by the same method as that for the conductive particles 1 except for using the mother particles 4 instead of the mother particles 1 and using PL-13 (mass concentration of 20%, available from Fuso Chemical Co., Ltd., brand name: Quartron PL-13, average particle diameter of 130 nm) instead of the colloidal silica dispersed solution PL-10.

(Conductive Particle 6)

The conductive particles 6 were produced by the same method as that for the conductive particles 1 except for using the mother particles 5 instead of the mother particles 1.

(Conductive Particle 7)

The conductive particles 7 were produced by the same method as that for the conductive particles 5 except for using the mother particles 6 instead of the mother particles 4.

(Example 1)

<Producing of Adhesive Solution>

One hundred grams of phenoxy resin (available from Union Carbide Corporation, brand name: PKHC) and 75 g of acrylic rubber (copolymer of 40 parts of butyl acrylate, 30 parts of ethyl acrylate, 30 parts of acrylonitrile, 3 parts of glycidyl methacrylate, molecular weight: 850,000) were dissolved in 300 g of ethyl acetate to prepare a 30%-by-weight solution.
Next, 300 g of liquid epoxy resin (epoxy equivalent of 185, available from Asahi Kasei Epoxy Co., Ltd., brand name: Novacure HX-3941) containing a microcapsule-type latent curing agent was added to the solution and stirred, whereby an adhesive solution was produced.

<Ultrasonic Dispersion of the Conductive Particles>

Four grams of the conductive particles 1 thus prepared was dispersed by ultrasonic waves in 10 g of ethyl acetate. The ultrasonic dispersion was performed under the following condition: a sample placed in a beaker was put in 38kHz400W20L (testing device, available from Fujimoto Science Co., Ltd., brand name: US107) and stirred for 1 minute.
The particle dispersed solution thus prepared was dispersed in the adhesive solution (such that the ratio of the conductive particles 1 to the adhesive was 21% by volume), and this solution was applied to a separator (a polyethylene terephtalate film treated with silicone, with a thickness of 40 $\mu$m) with a roll coater. The film was dried at 90 degrees C for 10 minutes, whereby an anisotropic conductive film with a thickness of 25 $\mu$m was produced.
Next, by using the produced anisotropic conductive film, a sample of a bonding structure for a chip (1.7 $\times$ 17 mm, thickness: 0.5 $\mu$m) including gold bumps (area: 30 $\times$ 90 $\mu$m, space: 10 $\mu$m, height: 15 $\mu$m, number of bumps: 362) and a glass substrate (thickness: 0.7 mm) with an Al circuit was produced by the method below.
First, the anisotropic conductive film (2 $\times$ 19 mm) was attached to the glass substrate with the Al circuit at 80 degrees C and at 0.98 MPa (10 kgf/cm$^2$). Subsequently, the separator was removed therfrom, and the bumps of the chip and the glass substrate with the Al circuit were aligned. Next, by applying heat and pressure from above the chip under a condition of 190 degrees C, 40 g/bump, and 10 seconds, actual bonding was performed to produce the sample.

(Example 2)

A sample was produced in the same manner as that in example 1 except for using the conductive particles 2 instead of the conductive particles 1.

(Example 3)

A sample was produced in the same manner as that in example 1 except for using the conductive particles 3 instead of the conductive particles 1.

(Example 4)

A sample was produced in the same manner as that in example 1 except for using the conductive particles 4 instead of the conductive particles 1.

(Example 5)

A sample was produced in the same manner as that in example 1 except for using the conductive particles 5 instead of the conductive particles 1.

(Comparative Example 1)

A sample was produced in the same manner as that in example 1 except for using the conductive particles 6 instead of the conductive particles 1.

(Comparative Example 2)

A sample was produced in the same manner as that in example 1 except for using the conductive particles 7 instead of the conductive particles 1.

(Measurement of Metal Film thicknesses)

The film thicknesses of Pd, Ni, and Au was measured by: desolving a sample in 50%-by-volume aqua regia; filtering out and removing resin by a membrane filter having a pore diameter of 3 $\mu$m (available from Millipore Corporation); measuring the sample by atomic absorption; and performing thickness conversion.

(Coverage of the Child Particles)

The coverage of the child particles (insulating particles) was calculated by taking electron micrographs of respective conductive particles and analyzing the images.

(Elution Test for the Particles)

One gram of the conductive particles 1 to 7 each was extracted and dispersed in 50 g of pure water. The sample was then put in a 60-ml pressure vessel, and left at 100 degrees C for 10 hours.
The conductive particle dispersed solvent was filtered by a filter with a 0.2-$\mu$m pore size, and each of the metal ions in the filtrate was measured by atomic absorption. The eluted amount was calculated by the following equation:
$$\{\text{Measured value of each ion (ppm)}\} = \{\text{Metal concentration in the eluted solution (ppm)}\} \times \{\text{Weight of pure water (g)}\} / \{\text{Weight of the conducive particles (g)}\}$$

(Insulation Resistance Test and Conductive Resistance Test)

Insulation resistance tests and conductive resistance tests were performed for the samples produced in examples 1 to 5 and comparative examples 1 and 2. It is important for an anisotropic conductive film to provide high insulation resistance between chip electrodes and low conductive resistance between chip electrodes and glass electrodes.
For the insulation resistance between chip electrodes, 20 samples were measured, and the minimum value thereof was measured. The insulation resistance is represented by the minimum value of results before and after performing a bias test (an endurance test at a humidity of 60%, a temperature of 90 degrees C, and a DC voltage of 20 V).
For the conductive resistance between chip electrodes and glass electrodes, the average value of 14 samples was measured. As for the conductive resistance, the initial value and the value after performing a moisture absorption and heat test (left under a condition of a temperature of 85 degrees C and a humidity of 85%, for 1000 hours) were measured.

(Results)

The measurement results of the respective examples described above are indicated in Table 1.
[Table 1]

| Items | | Example 1 | Example 2 | Example 3 | Example 4 | Example 5 | Comparative Example 1 | Comparative Example 2 |
|---|---|---|---|---|---|---|---|---|
| Conductive particles | | 1 | 2 | 3 | 4 | 5 | 6 | 7 |
| Silica coverage (%) | | 53 | 54 | 50 | 52 | 53 | 48 | 47 |
| Plating thickness (Å) | Ni plating | None | None | 300 | 300 | None | 700 | 700 |
| | Pd plating | 600 | 600 | 600 | 200 | 600 | None | 180 |
| | Au plating | None | 100 | None | None | None | 300 | None |
| Insulating particles (nm) | Particle diameter of silica for covering | $\phi$100 | $\phi$100 | $\phi$100 | $\phi$100 | $\phi$200 | $\phi$100 | $\phi$200 |
| Elution test (ppm) | Ni | 0 | 0 | 53 | 202 | 0 | 530 | 380 |
| | Pd | 9 | 0 | 1 | 0 | 12 | 0 | 8 |
| | Au | 0 | 1 | 0 | 0 | 0 | 0 | 0 |
| Insulation reliability test ($\Omega$) (60% humidity, 90 °C, 20 V) | 0 hours | $1.0 \times 10^{10}$ | $1.0 \times 10^{10}$ | $1.0 \times 10^{10}$ | $1.0 \times 10^{10}$ | $1.0 \times 10^{10}$ | $1.0 \times 10^{10}$ | $1.0 \times 10^{10}$ |
| | 100 hours | $1.0 \times 10^{10}$ | $1.0 \times 10^{10}$ | $1.0 \times 10^{10}$ | $1.0 \times 10^{10}$ | $1.0 \times 10^{10}$ | $<1.0 \times 10^{5}$ | $1.0 \times 10^{8}$ |
| | 200 hours | $1.0 \times 10^{10}$ | $1.0 \times 10^{10}$ | $1.0 \times 10^{10}$ | $1.0 \times 10^{8}$ | $1.0 \times 10^{10}$ | $<1.0 \times 10^{5}$ | $<1.0 \times 10^{5}$ |
| | 300 hours | $1.0 \times 10^{10}$ | $1.0 \times 10^{10}$ | $1.0 \times 10^{10}$ | $1.0 \times 10^{7}$ | $1.0 \times 10^{10}$ | $<1.0 \times 10^{5}$ | $<1.0 \times 10^{5}$ |
| Conductive resistance ($\Omega$) | Initial | <20 | <20 | <20 | <20 | <20 | <20 | 53 |
| | After moisture absorption test | <20 | <20 | <20 | <20 | <20 | <20 | >100 |

As listed in Table 1, in the particles containing no nickel in examples 1, 2, and 5, metals were scarcely eluted as indicated in the results of the elution test. In the particles in example 3, although the particles contained nickel, nickel was eluted only in a small amount because the thickness of the palladium layer as the outer layer was large. In the particles in example 4, nickel was eluted in a rather large amount because the thickness of the palladium layer as the outer layer was small.

By contrast, in comparative example 1 using gold plating on the outer layer, and in comparative example 2 using the thin palladium layer with a thickness of 180 Å or smaller, a larger amount of nickel tended to be eluted than the examples. Accordingly, it is safer not to use nickel in a COG substrate with narrow pitches. In the case where nickel is used, it is preferable that the nickel layer be coated with a palladium layer with a thickness of 200 Å or larger.

It is noted that palladium, which is a noble metal, is scarcely eluted. The results of the insulation reliability test practically depended on the eluted amount of nickel. It was obvious that the examples in which a small amount of nickel was eluted indicated excellent results, whereas the comparative examples in which a large amount of nickel was eluted had low insulation reliability.

As for conductivity, the results other than comparative example 2 indicated excellent results. By taking ion beam cross-sectional images of the respective samples and confirming the images, it was found that the results other than comparative example 2 provided conductivity in a manner where the child particles dented into Pd or Au parts, whereas comparative example 2 had the Pd layer (metal layer) being scarcely in contact with the electrodes because the thickness of the Pd layer was too small with respect to that of the insulating layer (diameter of silica absorbed on the mother particle). For this reason, the thickness of the insulating layer (diameter of silica absorbed on the mother particle) is preferably larger than the thickness of the Pd layer or the sum of the thicknesses of the Pd layer and the Au layer.

As illustrated in Table 1 and FIG. 4, because the samples (examples 1 to 5) produced according to the present invention had a high proportion of Pd (Au) on the surfaces thereof, thiol was likely to be chemisorbed on the surfaces of the particles. Accordingly, it was found that the separation of the child particles (silica) scarcely occurred before and after the ultrasonic dispersion. As for the insulation resistance in a mounting test, the samples (examples 1 to 5) produced according to the present invention had excellent yields because the child particles were hard to be separated.

By contrast, the samples produced in comparative examples 1 and 2 had a high proportion of nickel on the surface thereof. Accordingly, it was found that thiol was not likely to be chemisorbed on the surfaces of the particles, the bonding strength between silica and the mother particles was lowered, and thus silica was likely to be separated from the mother particles in the ultrasonic dispersion. As for the insulation resistance in the bonding test, the samples produced in comparative examples 1 and 2 were found to be likely to cause insulation failure. By eluting the prepared particles by methyl ethyl ketone, and performing SEM observation thereon, the child particles were found to be separated.

## Industrial Applicability

As described above, according to the present invention, a conductive particle that causes no migration, requires low cost, has high conductivity, and provides excellent connection reliability between electrodes, and a method for producing such a conductive particle can be provided.

## Claims

1. A conductive particle comprising:

   a core particle;
   a palladium layer coating the core particle and having a thickness of 200 Å or larger; and
   an insulating particle arranged on the surface of the palladium layer and having a particle diameter larger than the thickness of the palladium layer.

2. A conductive particle comprising:

   a core particle;
   a conductive layer coating the core particle;
   a palladium layer coating the conductive layer and having a thickness of 200 Å or larger; and
   an insulating particle arranged on the surface of the palladium layer and having a particle diameter larger than the sum of the thicknesses of the conductive layer and the palladium layer.

3. A conductive particle comprising:

a core particle;
a palladium layer coating the core particle and having a thickness of 200 Å or larger;
a gold layer coating the palladium layer; and
an insulating particle arranged on the surface of the gold layer and having a particle diameter larger than the sum of the thicknesses of the palladium layer and the gold layer.

4. The conductive particle according to claim 3, wherein the gold layer is a reduction plating type gold layer.

5. The conductive particle according to any one of claims 1 to 4, wherein the palladium layer is a reduction plating type palladium layer.

6. A method for producing a conductive particle, the method comprising:

forming a palladium layer on the surface of a core particle;
forming a functional group on the surface of the palladium layer by treating the surface of the palladium layer with a compound containing any of a mercapto group, a sulfide group and a disulfide group; and
immobilizing an insulating particle by chemisorption on the surface of the palladium layer having the functional group formed thereon.

7. A method for producing a conductive particle, the method comprising:

forming a conductive layer on the surface of a core particle;
forming a palladium layer on the surface of the conductive layer;
forming a functional group on the surface of the palladium layer by treating the surface of the palladium layer with a compound containing any of a mercapto group, a sulfide group and a disulfide group; and
immobilizing an insulating particle by chemisorption on the surface of the palladium layer having the functional group formed thereon.

8. The method for producing a conductive particle according to claim 6 or 7, wherein the insulating particle is immobilized on the surface of the palladium layer by chemisorption after the surface of the palladium layer having the functional group formed thereon is treated with a polymer electrolyte.

9. A method for producing a conductive particle, the method comprising:

forming a palladium layer on the surface of a core particle;
forming a gold layer on the surface of the palladium layer;
forming a functional group on the surface of the gold layer by treating the surface of the gold layer with a compound containing any of a mercapto group, a sulfide group and a disulfide group; and
immobilizing an insulating particle by chemisorption on the surface of the gold layer having the functional group formed thereon.

10. The method for producing a conductive particle according to claim 9, wherein the insulating particle is immobilized on the surface of the gold layer by chemisorption after the surface of the gold layer having the functional group formed thereon is treated with a polymer electrolyte.

11. The method for producing a conductive particle according to any one of claims 6 to 10, wherein the functional group is any of a hydroxyl group, a carboxyl group, an alkoxyl group and an alkoxycarbonyl group.

12. The method for producing a conductive particle according to claim 8 or 10, wherein the polymer electrolyte is polyamines.

13. The method for producing a conductive particle according to claim 12, wherein the polyamines is polyethylenimine.

14. The method for producing a conductive particle according to any one of claims 6 to 13, wherein the insulating particle is consisting essentially of an inorganic oxide.

15. The method for producing a conductive particle according to claim 14, wherein the inorganic oxide is silica.

*Fig.1*

# Fig.2

*Fig.3*

8c

1

11
12  2c
14

# Fig.4

(a)

(b)

(c)

<div align="center">

**INTERNATIONAL SEARCH REPORT**

</div>

| | International application No. |
|---|---|
| | PCT/JP2009/051964 |

**A. CLASSIFICATION OF SUBJECT MATTER**
*H01B5/00*(2006.01)i, *B22F1/02*(2006.01)i, *H01B13/00*(2006.01)i, *H01R11/01* (2006.01)i

According to International Patent Classification (IPC) or to both national classification and IPC

**B. FIELDS SEARCHED**

Minimum documentation searched (classification system followed by classification symbols)
H01B5/00, B22F1/02, H01B13/00, H01R11/01

Documentation searched other than minimum documentation to the extent that such documents are included in the fields searched
| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2005-44773 A (Sekisui Chemical Co., Ltd.), 17 February, 2005 (17.02.05), | 1-7,9,11, 14-15 |
| Y | Full text | 3-4 |
| A | & WO 2005/4172 A1 | 8,10,12-13 |
| X | WO 03/25955 A1 (Sekisui Chemical Co., Ltd.), 27 March, 2003 (27.03.03), | 1-7,9,11, 14-15 |
| Y | Full text | 3-4 |
| A | & US 2006/154070 A1 & EP 1426979 A1 | 8,10,12-13 |
| X | JP 4-259766 A (Hitachi Chemical Co., Ltd.), 16 September, 1992 (16.09.92), | 1-2,5 |
| Y | Full text | 3-4 |
| A | (Family: none) | 6-15 |

| ☒ | Further documents are listed in the continuation of Box C. | ☐ | See patent family annex. |
|---|---|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 15 May, 2009 (15.05.09) | 26 May, 2009 (26.05.09) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

| International application No. |
|---|
| PCT/JP2009/051964 |

C (Continuation).　DOCUMENTS CONSIDERED TO BE RELEVANT

| Category* | Citation of document, with indication, where appropriate, of the relevant passages | Relevant to claim No. |
|---|---|---|
| X<br>Y<br>A | JP 2007-537570 A　(Cheil Industries Inc.),<br>20 December, 2007 (20.12.07),<br>Full text<br>& US 2007/59503 A1　　　& WO 2005/109447 A1 | 1-2,5<br>3-4<br>6-15 |
| X<br>A | JP 2007-258141 A　(Hitachi Chemical Co., Ltd.),<br>04 October, 2007 (04.10.07),<br>Full text<br>& EP 2040268 A　　　　& WO 2008/4367 A1 | 1-5<br>6-15 |
| P,X | WO 2008/47600 A1　(Hitachi Chemical Co., Ltd.),<br>24 April, 2008 (24.04.08),<br>Full text<br>(Family: none) | 1-15 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP H8279371 A
- JP 2794009 B
- JP 2748705 B
- WO 0302955 A
- JP 2006028438 A
- JP 2001155539 A
- JP 2005036265 A

### Non-patent literature cited in the description

- *Thin Solid Films,* 1992, vol. 210, 211, 831
- *Langmuir,* 1997, vol. 13, 6195-6203